# EUROPÄISCHE PATENTSCHRIFT

(11) **EP 4 050 120 B1**
(45) Veröffentlichungstag und Bekanntmachung des Hinweises auf die Patenterteilung: **21.01.2026**
(21) Anmeldenummer: 22158173.9
(22) Anmeldetag: 23.02.2022
(51) Int. Cl.: C23C 14/32, C23C 14/06, C23C 14/16, C23C 14/02, C23C 14/56, H01M 8/0228

(54) **VORRICHTUNG ZUR OBERFLÄCHENBESCHICHTUNG EINES BANDFÖRMIGEN SUBSTRATS AUS EINEM METALL FÜR DIE HERSTELLUNG VON BIPOLARPLATTEN, ELEKTRODEN ODER ELEKTRISCHEN STROMABLEITERN**
DEVICE FOR SURFACE COATING OF A STRIP SUBSTRATE OF A METAL FOR THE PRODUCTION OF BIPOLAR PLATES, ELECTRODES OR ELECTRICAL CURRENT COLLECTORS
DISPOSITIF DE REVÊTEMENT DE SURFACE D'UN SUBSTRAT MÉTALLIQUE EN BANDE POUR LA FABRICATION DE PLAQUES BIPOLAIRES, D'ÉLECTRODES OU DE COLLECTEURS DE COURANT ÉLECTRIQUES

(30) Priorität: 24.02.2021 DE 102021201726
(43) Veröffentlichungstag der Anmeldung: 31.08.2022
(73) Patentinhaber: Fraunhofer-Gesellschaft zur Förderung der angewandten Forschung e.V., 80686 München (DE); Technische Universität Dresden, 01069 Dresden (DE)
(72) Erfinder: Maurizio, Giorgio, 01277 Dresden (DE); Roch, Teja, 01277 Dresden (DE); Steinhorst, Maximilian, 44145 Dortmund (DE); Topalski, Slavcho, 44145 Dortmund (DE)
(74) Vertreter: Pfenning, Meinig & Partner mbB

(56) Entgegenhaltungen:
- EP-A1- 0 492 592
- AU-B2- 639 469
- US-A1- 2019 316 249

## Beschreibung

Die Erfindung betrifft eine Vorrichtung zur Oberflächenbeschichtung eines bandförmigen Substrats aus Metall für die Herstellung von Bipolarplatten, Elektroden oder elektrischen Stromableitern für elektrochemische Zellen mit einer Beschichtung, die mit Kohlenstoff und/oder Metall gebildet ist. Bei den elektrochemischen Zellen handelt es sich primär um Brennstoffzellen oder Redox-Flow-Batterien.

Die Bipolarplatte, Elektroden oder elektrischen Stromableiter einer elektrochemischen Zelle, insbesondere einer Brennstoffzelle muss/müssen zwei Hauptfunktionen erfüllen. Zum einen dient sie als elektrischer Kontakt einer elektrochemischen Zelle, wofür eine hohe elektrische Leitfähigkeit benötigt wird. Zum anderen fungiert sie zur gleichmäßigen Verteilung der Prozessmedien (z.B. Wasserstoff, Sauerstoff). Während des Betriebes einer Brennstoffzelle reagieren die Prozessmedien Brennstoff und Oxidationsmittel zu Wasserdampf, der auf der Sauerstoffseite abgeführt wird. Jedoch kommt es hierbei häufig zur Akkumulation des Wasserdampfes und somit zur Bildung von kleinen Wassertropfen, die nur schwer abgeleitet werden können. Dies hat eine reduzierte Sauerstoffzufuhr zur Folge, wodurch letztlich die generierbare Leistung abnimmt. Es sind daher Oberflächenbeschichtungen mit verbesserter elektrischer Leitfähigkeit und Wasserabfuhr gefragt.

Momentan werden Beschichtungen für Bipolarplatten, Elektroden oder elektrischen Stromableiter in einem zeit- und kostenintensiven Batch-Prozess hergestellt. Zudem kommen unterschiedlichste Abscheideverfahren aus den Bereichen CVD und PVD, z.B. Niederdruck-CVD, Magnetronsputtern und Lichtbogenverdampfen für die Ausbildung von Oberflächenbeschichtungen auf Substraten von Bipolarplatten, Elektroden oder elektrischen Stromableiter zum Einsatz. Für eine zukünftige industrielle Skalierung der Produktionsprozesse ist eine möglichst vollständig kontinuierliche Fertigung inklusive der genannten Oberflächenfunktionalisierungen gewünscht.

Bislang wurde versucht durch neuartige aber gleichzeitig fertigungsintensive Flowfield Designs mit jeweils angepassten Kanalgeometrien die Wasserableitung aus der Zelle zu verbessern.

Die aktuellen Lösungsansätze im Bereich der Oberflächenbeschichtung adressieren momentan fast ausschließlich die Problematik der elektrischen Leitfähigkeit. Sie berücksichtigen jedoch die Wasserakkumulation nicht in ausreichendem Maß.

Es sind zwar Lösungsansätze bekannt, bei denen elektrisch leitfähige und hydrophobe Oberflächenbeschichtungen, die aus bzw. mit Kohlenstoffschichten ausgebildet sind. Dabei ergeben sich aber Probleme, die sich insbesondere bei einer kontinuierlichen Fertigung und Beibehaltung einer gleichbleibenden Qualität negativ auswirken.

So ist es prinzipiell bekannt Bipolarplatten mit Kohlenstoffbeschichtungen mit überwiegend in sp2-Modifikation vorliegendem Kohlenstoff zu beschichten und dabei auch das Verfahren der elektrischen Lichtbogenbeschichtung anzuwenden. Es haben sich aber Schwierigkeiten dabei bei der großflächigen Beschichtung im kontinuierlichen Durchlaufbeschichtungsverfahren ergeben. Insbesondere bewirken diese inhomogenen und ungleichmäßigen Beschichtungen.

Ein weiteres Problem bei einer kontinuierlichen und homogenen Beschichtungsausbildung besteht darin, dass es ohne eine an das zu beschichtende Substrat angelegte recht hohe negative BIAS-Spannung zu Verlusten an Beschichtungswerkstoff kommen kann, da die erforderlichen Energien mit denen die Kohlenstoff-Ionen an der jeweiligen zu beschichtenden Oberfläche nicht zur Verfügung stehen. Legt man aber eine entsprechend geeignete BIAS-Spannung an das sich bewegende Substrat an, kann es zu Problemen durch Spannungsabrisse oder Kurzschlüsse am Substrat kommen, was wiederum Inhomogenitäten in der Beschichtung zur Folge haben kann.

Werden Kohlenstoffschichten mittels elektrischer Lichtbogenentladungen ausgebildet, kann es ohne Gegenmaßnahmen zu einem ungleichförmigen Werkstoffabtrag wegen eines sich unkontrolliert bewegenden elektrischen Lichtbogens auf der Oberfläche eines als Kathode geschalteten Targets, das mit Kohlenstoff gebildet ist, kommen. Dies kann ebenfalls zu einer nicht homogenen Schichtbildung über die gesamte Fläche führen. Außerdem ist der Ausnutzungsgrad des eingesetzten Kohlenstoffs reduziert, so dass ein Graphittarget häufiger ausgetauscht werden muss, als eigentlich nötig, da sich insbesondere eine unkontrollierte Kraterbildung an der Oberfläche dafür nachteilig auswirkt.

Die aktuell eingesetzte Verdampfertechnologie zeichnet sich dadurch aus, dass zwischen der Kathode (Beschichtungsmaterial) und dem zu beschichtenden bandförmigen Substrat eine elektrische Potentialdifferenz herrscht. Jedoch ist das Anlegen eines hohen elektrischen Potentials an ein Stahlband als Substrat für Bipolarplatten, Elektroden oder elektrischen Stromableiter im Zuge einer industriellen Fertigung im kontinuierlichen Bandprozess nicht ohne weiteres möglich. Dies ist durch anlagen- und fertigungstechnische Restriktionen begründet, was z.B. die erforderliche Vakuumtechnik, Sicherheitsaspekte (freistehende, spannungsbeaufschlagte Coils) oder einen komplexen Verfahrensablauf betrifft. Durch die Entwicklung einer neuen Verdampfertechnologie sollte eine potentialfreie Bandbeschichtung mit bereits etablierten Beschichtungsverfahren realisiert werden können.

Das Ziel einer Beschichtung einer metallischen Bipolarplatte, Elektrode oder eines elektrischen Stromableiters ist die bereits gute intrinsische elektrische Leitfähigkeit des Substratwerkstoffs (bevorzugt Edelstahl) weiter zu erhöhen. Mittels der Abscheidung eines kohlenstoffbasierenden, graphitähnlichen Schichtsystems, das einen hohen Anteil an sp²-Bindungen aufweist, kann dies erreicht werden. Neben der Zusammensetzung der Kammeratmosphäre haben weitere Prozessparameter, wie beispielsweise die Temperatur (100 °C - 400 °C) oder Druck (0,01 Pa - 1 Pa), einen erheblichen Einfluss auf das Schichtwachstum und die resultierenden Eigenschaften. Dementsprechend sollte zum Erzielen spezifischer Schichteigenschaften (Hydrophobie, elektrische Leitfähigkeit der Beschichtung) der Beschichtungsprozess individuell angepasst werden können.

So ist in US 2019/0316249 A1 ein Verfahren zur Ausbildung einer Schicht auf einem Substrat beschrieben, bei das Magnetronsputtern angewendet wird.

Aus EP 0 r492 592 A1 ist eine Vakuum-Bogen-Beschichtungs-Vorrichtung bekannt.

AU 639 469 B2 betrifft ein Verfahren und eine Vorrichtung zur Behandlung von Bauteilen mit elektrischen Bogenentladungen.

Es ist daher Aufgabe der Erfindung, Möglichkeiten für eine kontinuierliche Ausbildung von Oberflächenbeschichtungen auf Basis von Kohlenstoff, die aus kristallinem, zumindest überwiegend kristallinem Kohlenstoff gebildet sind, anzugeben, bei denen auch eine gleichbleibende Qualität der Beschichtung innerhalb eines vorgegebenen Oberflächenbereichs eines Substrats, das für die Herstellung von Bipolarplatten, Elektroden oder elektrischen Stromableiter eingesetzt wird, und über einen längeren Zeitraum eingehalten werden kann. Außerdem sollten Unterbrechungen des Beschichtungsprozesses weitestgehend vermieden werden können.

Erfindungsgemäß wird diese Aufgabe mit einer Vorrichtung, die die Merkmale des Anspruchs 1 aufweist, gelöst. Vorteilhafte Ausgestaltungen und Weiterbildungen der Erfindung können mit in abhängigen Ansprüchen bezeichneten Merkmalen realisiert werden.

Um eine effektive Fertigung funktionalisierter Bipolarplatten, Elektroden oder elektrischen Stromableiter zu realisieren kann ein so genanntes Roll-to-Roll Verfahren, also einem Verfahren bei dem ein bandförmiges Substrat von einer Rolle kontinuierlich abgewickelt und nach der Ausbildung einer Oberflächenbeschichtung entweder wieder aufgerollt oder direkt im Anschluss daran weiter prozessiert und dabei insbesondere mit einem Trennverfahren zu vereinzelten Bipolarplatten, Elektroden oder elektrischen Stromableiter ggf. mit zusätzlicher Formgebung weiterverarbeitet wird. Ziel ist es dabei, dass ein Coil des Substratwerkstoffs unter normalen Umgebungsatmosphärenbedingungen an Luft abgewickelt, dann in eine Vakuumkammer über Schleusen für eine Durchführung weiterer Prozessschritte, hauptsächlich Beschichtungsprozesse ein- und hindurchgeführt und letztlich das prozessierte Band wieder aufgewickelt oder weiterbearbeitet werden kann.

Üblicherweise werden in den einzelnen Prozessschritten unterschiedliche in der Regel recht hohe BIAS-Spannungen, die im Bereich mehrerer hundert Volt liegen, an das Band als zu beschichtendes Substrat angelegt. Dabei kommt es bei einem angestrebten Durchlaufprozess zu Kontaktierungsproblemen, bei denen es am jeweiligen Band zu elektrischen Überschlägen kommen kann, die wiederum zu einer Schädigung der Substratoberfläche oder auch zu ungleichförmig ausgebildeten Oberflächenbeschichtungen führen können, was insbesondere deren Schichtdicken und inhomogenen Werkstoffzusammensetzungen der Oberflächenbeschichtung betrifft. Um diese Problematik zu lösen, wird eine Technik zur potentialfreien Bandbeschichtung vorgeschlagen. Dies soll mit einer neuen Verdampfertechnologie realisiert werden, bei der der vorteilhafte elektrische Potentialunterschied durch mindestens eine Hilfselektrode, die zwischen dem Substrat und der eigentlichen Verdampferquelle, im konkreten Fall ein Target, das aus einem Metall oder Kohlenstoff, insbesondere Graphit besteht und als Anode geschaltet ist, angeordnet ist. Mit der mindestens einen Hilfselektrode können Ionen eines vorab generierten Plasmas in ihrer Bewegung in Richtung Substratoberfläche beeinflusst werden. Dadurch kann eine homogene Beschichtung aus Metall und/oder Kohlenstoff über die jeweils gewünschte elektrisch bzw. elektrochemisch aktive Fläche von Bipolarplatten, Elektroden oder elektrischen Stromableiter erhalten werden.

Bei der erfindungsgemäßen Vorrichtung wird metallisches bandförmiges Substrat, bevorzugt aus Edelstahl in einer Vakuumkammer beschichtet, dabei wird es bevorzugt kontinuierlich mit möglichst konstanter Geschwindigkeit translatorisch durch die Vakuumkammer geführt. Dabei ist das bandförmige Substrat in einem Abstand und parallel zur Längsachse eines stabförmigen Targets, das aus einem reinen Metall, wie z.B. Cr, Mo, Cu, Al, Ti, Ta, W, V, Au, Nb, Hf, Ag oder Zr, einer Legierung davon oder auch Kohlenstoff in Form von Graphit besteht, angeordnet und ausgerichtet. Es kann auch ein Nitrid eines dieser Metalle eingesetzt werden. Das stabförmige Target kann senkrecht zu seiner Längsachse einen runden oder mehreckigen Querschnitt aufweisen.

Das stabförmige Target ist an den negativen Pol einer ersten elektrischen Spannungsquelle angeschlossen. In einem Abstand zu dem stabförmigen Target ist eine Anode oder ggf. eine Zündelektrode, die an den positiven Pol der ersten elektrischen Spannungsquelle angeschlossen ist, angeordnet. Die erste elektrische Spannungsquelle ist gepulst oder kontinuierlich zur Zündung und Aufrechterhaltung elektrischer Bogenentladungen zwischen der Anode und dem stabförmigen Target betreibbar.

Außerdem ist mindestens eine Hilfselektrode, die an den positiven Pol einer zweiten elektrischen Spannungsquelle angeschlossen ist, in einem Abstand zum stabförmigen Target und parallel zur Längsachse des stabförmigen Targets und zumindest teilweise zwischen dem bandförmigen Substrat und der Oberfläche des stabförmigen Targets angeordnet. Mit dem Einsatz einer Hilfselektrode und/oder einem elektrisch leitenden, streifen- oder gitterförmigen Element, das parallel zur Oberfläche des bandförmigen Substrats ausgerichtet, zwischen der Hilfselektrode und dem bandförmigen Substrat angeordnet und an den negativen Pol der zweiten elektrischen Spannungsquelle angeschlossen ist, kann man auf das Anlegen einer negativen elektrischen BIAS-Spannung an das bandförmige Substrat verzichten und die damit eigentlich verbundenen Nachteile vermeiden.

Die Hilfselektrode könnte mit mindestens einem oder mit mindestens zwei rechteckigen plattenförmigen Element(en) gebildet sein. Mindestens zwei plattenförmige Elemente könnten in einem Abstand zueinander und dabei das stabförmige Target zwischen den plattenförmigen Elementen angeordnet sein. Erfindungsgemäß ist eine Hilfselektrode mit einem v-förmig oder u-förmig konkav in Richtung auf das stabförmige Target gekrümmt gebildet, so dass Ionen des mittels elektrischer Lichtbogenentladungen generierten Plasmas zwischen den plattenförmigen Elementen oder den Schenkeln einer v- oder u-förmig gekrümmten Hilfselektrode angeordnet sind und mittels des von der Hilfselektrode generierten elektrischen Feldes zwischen den plattenförmigen Elementen oder den Schenkeln in Richtung einer zu beschichtenden Oberfläche des bandförmigen Substrats zusätzlich in ihrer Bewegung in Richtung der zu beschichtenden Oberfläche des bandförmigen Substrats beeinflusst werden. Günstig ist es dabei, wenn die plattenförmigen Elemente oder die Schenkel in einem schräg geneigten Winkel ausgerichtet sind, so dass der Abstand zwischen den Stirnseiten der längeren Seiten der plattenförmigen Elemente oder der Schenkel, die in Richtung des stabförmigen Graphittargets angeordnet sind, kleiner als der Abstand ihrer Stirnseiten ist, die in Richtung des bandförmigen Substrats angeordnet sind. Es können auch mehrere plattenförmige Elemente oder gekrümmte Hilfselektroden in einer Reihenanordnung anstelle eines einzigen plattenförmigen Elements oder einer einzigen gekrümmten Hilfselektrode angeordnet werden. Dabei können zwei Reihenanordnungen gegenüberliegend zueinander angeordnet sein oder eine Hilfselektrode mit einer Reihenanordnung mehrere v- oder u-förmig bzw. konkav gekrümmter plattenförmiger Elemente gewählt werden, wobei das stabförmige Target, die Anode und die Zündelektrode analog angeordnet sein sollten.

Es kann auch ein plattenförmiges Element einer Hilfselektrode v- oder u-förmig konkav gekrümmt, in Richtung bandförmiges Substrat offen und das stabförmige Target im Inneren und in einem Abstand zu dem v-förmigen oder u-förmigen konvex gekrümmten plattenförmigen Element angeordnet sein, um die Bewegung der Ionen des gebildeten Plasmas in Richtung der zu beschichtenden Oberfläche des bandförmigen Substrats zu beeinflussen. Es besteht auch die Möglichkeit im Bereich des Bodens, unterhalb des stabförmigen Targets ein weiteres elektrisch leitendes Element vorzusehen, das unterhalb der in diese Richtung weisenden Stirnseiten von zwei plattenförmigen Elementen angeordnet sein kann. Damit kann eine Anordnung geschaffen werden, die ähnlich, wie eine einzelne gekrümmte Hilfselektrode wirken kann. Dazu kann dieses weitere elektrisch leitende Element auf das gleiche elektrische Spannungspotential, wie die zwei plattenförmigen Elemente gelegt sein.

Allein oder zusätzlich kann auch ein elektrisch leitendes, gitter- oder streifenförmiges Element zwischen der Oberfläche des stabförmigen Targets, auf der die Fußpunkte von elektrischen Lichtbögen ausgebildet sind, und dem bandförmigen Substrat angeordnet und an einen negativen Pol einer zweiten elektrischen Spannungsquelle angeschlossen sein. So können beschleunigte Ionen durch Maschen eines Gitters oder zwischen Streifen eines solchen gitter- oder streifenförmigen Elements in Richtung auf die zu beschichtende Oberfläche des bandförmigen Substrats zur Ausbildung der Beschichtung gelangen. Streifen sollten bevorzugt parallel zueinander ausgerichtet und äquidistant zueinander angeordnet sein. Dabei sollten die Maschenweite und die Abstände von Streifen sowie die Materialdicke eines Gitters oder die Breite von Streifen mit den Zwischenräumen so gewählt sein, dass zumindest 50 %, bevorzug mindestens 70 % und besonders bevorzugt mindestens 90 % der Ionen ungehindert auf die entsprechende Oberfläche des bandförmigen Substrats auftreffen.

Ein elektrisch leitendes gitter- oder streifenförmiges Element sollte eine Fläche, inklusive der Zwischenräume zwischen Maschen eines Gitters oder zwischen Streifen durch die Ionen zur Beschichtung der Oberfläche des bandförmigen Materials gelangen können, aufweisen, die mindestens 50 %, bevorzug mindestens 70 % und besonders bevorzugt mindestens 90 % der Gesamtfläche der Fläche der zu beschichtenden Oberfläche des bandförmigen Substrats, die gleichzeitig beschichtet wird, entspricht.

Bei einer Ausführungsform, bei der eine Hilfselektrode mit mindestens einem plattenförmigen Element und ein gitter- oder streifenförmiges Element gemeinsam in einer Vakuumkammer vorhanden sind, ist es vorteilhaft wenn an eine plattenförmige Hilfselektrode eine elektrische Spannung angelegt ist, deren absoluter Betrag mindestens zweifach, bevorzugt vierfach und besonders bevorzugt mindestens zehnfach kleiner ist, als eine elektrische Spannung, die an ein gitter- oder streifenförmiges Element angelegt ist.

Ein oder mehrere in Reihe angeordnete bevorzugt rechteckige(s) plattenförmige Element(e) einer Hilfselektrode sollte(n) an seiner langen Seite eine Länge aufweisen, die mindestens 90 % der Länge eines jeweiligen stabförmigen Targets aufweist.

An die mindestens eine Hilfselektrode, die mit einem oder mehreren plattenförmigen Elementen gebildet ist, und/oder ein elektrisch leitendes gitter- oder streifenförmiges Element sollte eine elektrische Spannung zwischen 5 V und 1500 V angelegt sein.

In einer vorteilhaften Ausführungsform können mehrere Permanent- oder Elektromagnete in einer Reihenanordnung zumindest an der Seite des stabförmigen Targets, die dem bandförmigen Substrat abgewandt ist, mit jeweils einem Abstand zwischen den einzelnen Permanent- oder Elektromagneten ausgehend von einem stirnseitigen Ende des stabförmigen Targets bis zu dessen gegenüberliegend angeordneten stirnseitigen Ende angeordnet sein. Sie können also ähnlich wie eine Kette, bei der die einzelnen Glieder nicht direkt miteinander verbunden sind, jedoch vorteilhaft in einer gemeinsamen Ebene parallel zur Längsachse des stabförmigen Targets angeordnet sein.

Mit den Magnetfeldern der so angeordneten Permanent- oder Elektromagnete kann der Fußpunkt eines gezündeten elektrischen Lichtbogens an der Oberfläche des stabförmigen Targets ausgehend von der Stirnseite des stabförmigen Targets, die an der Anode angeordnet ist, in Richtung des gegenüberliegenden Stirnendes des stabförmigen Targets geführt werden, so dass über seine Länge ein gleichmäßigerer Werkstoffabtrag an der Oberfläche des stabförmigen Targets erreichbar ist.

Der Einsatz von Permanent- oder Elektromagneten ist bei einem stabförmigen Target, das aus Kohlenstoff, bevorzugt in Form von Graphit besteht, besonders vorteilhaft.

Es kann auch ein weiterer Permanent- oder Elektromagnet am stirnseitigen Ende des stabförmigen Targets, das dem stirnseitigen Ende, an dem die Anode oder bevorzugt eine Zündelektrode angeordnet ist, gegenüberliegt, angeordnet und so ausgebildet oder betreibbar sein, dass ein gezündeter elektrischer Lichtbogen ausgelöscht wird, wenn sein Fußpunkt an der Oberfläche des stabförmigen Targets den Bereich des Magnetfeldes des einen weiteren Permanent- oder Elektromagneten, der am stirnseitigen Ende des stabförmigen Targets angeordnet ist, erreicht hat. Nach oder einem Zeitpunkt vor dem Erlöschen dieses elektrischen Lichtbogens kann ein nachfolgender elektrischer Lichtbogen an der Seite des stabförmigen Targets mit Hilfe einer dort angeordneten Zündelektrode, die an einen positiven Pol der ersten oder einer weiteren elektrischen Spannungsquelle angeschlossen ist, gezündet werden. Bei mehreren gleichzeitig betriebenen elektrischen Lichtbögen sollte jedoch gesichert sein, dass sich zumindest ihre Fußpunkte an der Oberfläche des stabförmigen Targets nicht gegenseitig beeinflussen. Dies kann beispielsweise durch eine geeignete Pulsfrequenz der Zündung elektrischer Lichtbögen erreicht werden. Die Zündelektrode sollte mit einer elektrischen Spannung im Bereich 20 V bis 30 V, bevorzugt bei 25 ± 1 V betrieben werden. Bei einer Zündung eines elektrischen Lichtbogens kann eine elektrische Spannung im Bereich 60 V bis 80 V genutzt werden. Der elektrische Strom, der dabei fließt ist abhängig vom Werkstoff des stabförmigen Targets und kann im Bereich 50 A bis 400 A liegen.

Vorteilhaft kann die Hilfselektrode, die mit einem gekrümmten oder mehreren plattenförmigen Elementen gebildet ist, gekühlt werden. Dazu kann ein in geeigneter Form temperiertes Fluid genutzt und direkt auf eine Hilfselektrode als Gasstrom oder in Form einer Flüssigkeitskühlung eingesetzt werden.

Für eine verbesserte Führung von Fußpunkten elektrischer Lichtbögen können die Permanent- oder Elektromagneten ausgehend von dem stirnseitigen Ende des stabförmigen Targets, an dem die Zündelektrode oder Anode angeordnet ist, bis zu dem gegenüberliegend angeordneten stirnseitigen Ende des stabförmigen Targets Magnetfelder mit jeweils gleicher Ausrichtung der Feldlinien generieren. Dabei sollte die Feldstärkte der von den Permanent- oder Elektromagneten generierten Magnetfelder ausgehend von dem stirnseitigen Ende des stabförmigen Targets, an dem die Anode angeordnet ist, bis zu dem gegenüberliegend angeordneten stirnseitigen Ende des stabförmigen Targets bevorzugt kontinuierlich ansteigen und/oder sich der Abstand zwischen unmittelbar nebeneinander angeordneten Permanent- oder Elektromagneten verkleinern. Es kann so abstandsabhängig von der Anode besser Einfluss auf die Bewegung des jeweiligen Fußpunktes eines elektrischen Lichtbogens mit der Kraftwirkung der Magnetfelder genommen werden.

Der weitere Permanent- oder Elektromagnet kann ein Magnetfeld generieren dessen Polung entgegengesetzt zu den von den Permanent- oder Elektromagneten generierten Magnetfeldern gewählt ist und/oder das vom weiteren Permanent- oder Elektromagnet generierte Magnetfeld kann eine größere Feldstärke als die Magnetfelder der von den Permanent- oder Elektromagneten generierten Magnetfelder aufweisen. Allein oder zusätzlich zu diesen Maßnahmen kann der weitere Permanent- oder Elektromagnet über die in Richtung des bandförmigen Substrats weisende Oberfläche des stabförmigen Targets hinausragen.

Die in Reihe angeordneten Permanent- oder Elektromagnete können U-förmig ausgebildet und so ausgerichtet sein, dass ihre offene Seite in Richtung bandförmiges Substrat weisend angeordnet ist, wodurch die Wirkung ihrer Magnetfelder auch dazu genutzt werden kann, den Fußpunkt des jeweils gezündeten elektrischen Lichtbogens auf einem bestimmten Oberflächenbereich des stabförmigen Targets zwischen den jeweiligen Schenkeln der Permanent- oder Elektromagneten zu halten.

Bei der Erfindung können vorteilhaft mehrere Vakuumkammern, die wie vorab beschrieben, ausgebildet sein können, in Vorschubbewegungsrichtung des bandförmigen Substrats nacheinander in einer Reihenanordnung zur Ausbildung der Beschichtung, die mit Metall und/oder Kohlenstoff gebildet ist und/oder einer Modifizierung an der Oberfläche des bandförmigen Substrats in Form einer Nitrierung, Carburierung und/oder Nitrier-Carburierung angeordnet sein.

So können eine erste Vakuumkammer, die für eine Plasmafeinreinigung ausgebildet ist, in Vorschubbewegungsrichtung des bandförmigen Substrats anschließend an die erste Vakuumkammer eine zweite Vakuumkammer, die für eine Modifizierung an der Oberfläche des bandförmigen Substrats in Form einer Nitrierung und/oder zur Ausbildung einer metallischen Zwischenschicht, ausgebildet ist und daran nachfolgend mindestens eine weitere Vakuumkammer, die zur Beschichtung des bandförmigen Substrats mit dem Metall des stabförmigen Targets oder mit dem Kohlenstoff ausgebildet ist, nacheinander angeordnet sein. So lassen sich sukzessive nacheinander eine Feinreinigung, eine Nitrierung an der Oberfläche des bandförmigen Substrats und dann die Ausbildung der Beschichtung auf dem Substrat oder nach der Feinreinigung der Oberfläche des bandförmigen Substrats eine metallische Zwischenschicht, mit der beispielsweise die Haftung verbessert oder eine Diffusion verhindert werden kann, durchgeführt werden, bevor die Beschichtung auf der Oberfläche des bandförmigen Substrats ausgebildet wird. Es kann aber auch lediglich in einer Vakuumkammer eine Feinreinigung, bevorzugt in Form einer Plasmafeinreinigung und anschließend daran in einer weiteren Vakuumkammer die Beschichtung ausgebildet werden.

So kann man in mindestens einer der Vakuumkammern die Beschichtung mit dem Metall oder Kohlenstoff des stabförmigen Targets vornehmen. Zur Sicherung einer vollständig homogenen Beschichtung mit dem Metall oder Kohlenstoff über die jeweils gewünschte Oberfläche des bandförmigen Substrats kann man dazu auch mindestens zwei nacheinander in Vorschubbewegungsrichtung des bandförmigen Substrats angeordnete Vakuumkammern für diesen Zweck nutzen. Mehrere solche Vakuumkammern ermöglichen auch eine kontinuierliche Beschichtung, wenn in einer Vakuumkammer ein Austausch eines stabförmigen Targets erforderlich ist und durchgeführt wird.

In mindestens einer Vakuumkammer kann aber auch vor dem Ausbilden der Beschichtung aus Kohlenstoff eine Oberflächenbehandlung des bandförmigen Substrats durchgeführt werden. Dazu kann in die jeweilige Vakuumkammer ein entsprechendes Reaktivgas eingeleitet werden, in dem Stickstoff und/oder Kohlenstoff enthalten ist, um eine Nitrierung, Carburierung oder beides an der Oberfläche zu erreichen. In diesem Fall kann man in einer dafür entsprechend ausgebildeten Vakuumkammer auf ein Target verzichten und lediglich eine Kathode einsetzen, die den Oberflächenmodifizierungsprozess mit dem Reaktivgas nicht direkt beeinflussen muss und lediglich die erforderliche Energie zur Verfügung stellen kann.

Vorteilhaft für einen kontinuierlichen Beschichtungsprozess kann man insbesondere Kathodenmaterial aus Metall oder Kohlenstoff (Graphit )möglichst ,inline' und ohne nennenswerte Verzögerungen innerhalb einer Vakuumkammer austauschen bzw. ein Target wechseln. Hierfür kann man ein Mehrkammersystem an einer Vakuumkammer einsetzen, das ähnlich einem Revolver konstruiert sein kann und mit dem ein Austausch eines verbrauchten stabförmigen Targets gegen ein neues stabförmiges Target, ohne nennenswerte Unterbrechung des Beschichtungsprozesses und mit dem keine Unterbrechung der Vakuumbedingungen innerhalb der jeweiligen Vakuumkammer erforderlich ist, möglich ist. Ein Mehrkammersystem kann dazu an eine Vakuumkammer angeflanscht werden. Im Mehrkammersystem können einzelne Kammern zur Aufnahme stabförmiger Targets vorhanden sein. Durch eine Bewegung des Mehrkammersystems kann eine leere Kammer entsprechend positioniert werden, um ein verbrauchtes stabförmiges Target aufzunehmen. Anschließend kann eine weitere Bewegung erfolgen bei der eine weitere Kammer so positioniert wird, dass ein neues unverbrauchtes stabförmiges Target aus dieser Kammer in seine gewünschte Position innerhalb der Vakuumkammer angeordnet werden kann. Das Mehrkammersystem sollte dabei eine Vakuumschleuse bilden und/oder durch rotierende Bewegung die jeweiligen Kammern in die jeweils gewünschte Position bewegt werden können.

Durch die Beschichtung des bandförmigen Substrats für die Herstellung von Bipolarplatten, Elektroden oder elektrischen Stromableitern, die an der Oberfläche mit einer metallischen oder graphitähnlichen Kohlenstoffschicht (GLC) versehen worden sind, kann eine signifikante Steigerung der elektrischen Leitfähigkeit erreicht werden. Zudem ist eine Verbesserung der Korrosionsbeständigkeit zu erwarten, wenn geeignete metallische Zwischenschichten in an sich bekannter Art und Weise ausgebildet werden (z.B. Cr, Mo, Ti, Ag, Ta, Nb, Ru, Rh, W, V, Au, Zr Al, Cu, Hf). Für die genannten Zwischenbeschichtungen kann prinzipiell ebenfalls das elektrische Lichtbogenverfahren (engl. cathodic arc deposition) sowohl im gepulsten als auch bevorzugt im ungepulsten Modus im Hochvakuum eingesetzt werden.

Bei elektrischen Lichtbogenentladungen kann eine Hochstromentladung (Kurzschluss) durch einen bevorzugt kurzzeitigen mechanischen Kontakt auf der Kathode, vorteilhaft mit einer Zündelektrode induziert werden. Dadurch wird ein elektrischer Lichtbogen zwischen einer Anode und dem als Kathode geschalteten Target gezündet, dessen Fußpunkt sich auf der Kathodenoberfläche bewegen kann. Mit der Energie des elektrischen Lichtbogens wird an der Oberfläche des Targets ein Plasma generiert mit dessen Ionen die Oberflächenbeschichtung auf einer jeweiligen Substratoberfläche ausgebildet werden kann. Die bei der Plasmabildung ausgestoßenen Atome werden dabei infolge von Kollisionen mit emittierten Elektronen ionisiert und die frei gesetzten Ionen in Richtung des Substrats beschleunigt. Diese Technik zeichnet sich durch hohe Abscheideraten von mehreren zehntel Mikrometern pro Minute und den erreichbaren sehr hohen Ionisierungsgraden, zum Teil bis zu 95 % aus.

Andere Abscheideverfahren aus dem Bereich der CVD benötigen im Gegensatz dazu häufig sehr hohe Prozesstemperaturen (> 500 °C) und verwenden zum Teil toxische oder anderweitig sicherheitskritische Gase. Dazu kommen, eine häufig sehr lange Prozessdauer von mehreren Stunden sowie eine komplexe Behandlung der prozessbedingten Abgase.

Neben einer metallischen Zwischenschicht sind weitere Varianten möglich, die die Korrosionsbeständigkeit erhöhen, wie z.B. das Plasmanitrieren mittels AEGD-Verfahren und anschließender Kohlenstoffbeschichtung. Beim AEGD-Verfahren wird vor einen Metallverdampfer eine Blende gefahren, womit die Ionen abgefangen und nur die emittierten Elektronen zur Hilfselektrode (AEGD) gelangen. Dadurch wird das Plasma angeregt. Mit dem Einlassen von Stickstoff werden letztendlich die Nitrierprozesse gestartet. Über ein Anheben der AEGD-Spannung kann die Plasmaintensität gesteigert werden. Die nachfolgende Beschichtung mit Metall oder Kohlenstoff kann mit dem oben beschrieben Lichtbogenverfahren erfolgen.

Aufgrund der Durchführung der einzelnen Prozessschritte in einem kontinuierlichen Bandprozess mittels eines Roll-to-Roll Verfahrens werden die Kosten gesenkt und die Produktivität gesteigert.

Dies kann vorteilhaft in Brennstoffzellen in der Automobilindustrie, bei der Wasserstoffelektrolyse sowie bei Batterieanwendung (z.B. Redox-Flow Batterien) eingesetzt werden.

Zusätzlich ist es für einen reibungslosen Prozessablauf in einer zukünftigen Produktion vorteilhaft, eine möglichst lange Lebensdauer pro Kathode (Target) aus Metall oder Kohlenstoff (Graphit) zu erzielen. Mittels einer Schleusentechnik mit Mehrkammersystem kann ein Wechsel von stabförmigen Graphittargets im Hochvakuum, d.h. während des Betriebs, ermöglicht werden. Ein System angelehnt an ein Revolvermagazin mit mehreren bewegbaren, bevorzugt drehbaren Kammern in denen jeweils ein stabförmiges Target aufgenommen ist, ist beispielsweise eine Realisierungsmöglichkeit zur Einhaltung einer möglichst dauerhaft kontinuierlichen Verfahrensdurchführung.

Zur Gewährleistung einer homogenen Beschichtung können mehrere erfindungsgemäß ausgebildete und betreibbare Vakuumkammern in Bewegungsrichtung des bandförmigen Substrats in Reihe nacheinander angeordnet werden. Dabei können die Vakuumkammern mit einem Schleusensystem versehen sein, um die Vakuumbedingungen einhalten zu können.

Mit Hilfe einer intelligenten Steuerung zwischen der eigentlichen Verdampfereinheit (Anode, Kathode und Bandlauf) können die jeweiligen Zeitpunkte einer Zündung eines elektrischen Lichtbogens an die jeweilige Vorschubbewegungsgeschwindigkeit des bandförmigen Substrats angepasst und eine Synchronisierung erreicht werden. Für den Fall, dass ein elektrischer Lichtbogen zwischen Anode und stabförmigen Target als Kathode erlischt, kann unmittelbar im Anschluss daran eine in Vorschubbewegungsrichtung nachfolgend angeordnete Vakuumkammer mit stabförmigem Target, Anode und gitter- oder streifenförmigem elektrisch leitenden Element und/oder Hilfselektrode aktiviert und für die Schichtausbildung an der Substratoberfläche genutzt werden, wodurch Fehlstellen vermieden und letztlich die Prozessstabilität erhöht werden können. Mehrere so angeordnete Vakuumkammern können aber auch gleichzeitig betrieben werden, um Inkontinuitäten während der jeweiligen Beschichtungsprozesse zu kompensieren und eine homogene gleichdicke Kohlenstoffschicht zu erhalten.

Vor der eigentlichen Behandlung und Beschichtung eines bandförmigen Substrats kann eine nasschemische Reinigung zum Entfernen von Fett-, Öl- und Produktionsrückständen erfolgen. Die jeweiligen Oberflächen können aber auch allein oder zusätzlich mittels Plasma oder Ionenbeschuss in an sich bekannter Weise von Oberflächenkontaminationen, bevorzugt als Feinreinigung durchgeführt, befreit werden.

In den jeweiligen Vakuumkammern sollte ein Hochvakuum von bis zu 0,01 Pa eingehalten werden, wobei Schleusen am Ein- und Auslauf einer jeweiligen Vakuumkammer entsprechend ausgebildet sein sollten, um dieses Vakuum auch dauerhaft während eines kontinuierlich betriebenen Beschichtungsprozesses einhalten zu können.

Die jeweilige Vakuumkammer sollte vor dem Beginn der Ausbildung einer Beschichtung auf eine Temperatur zwischen 100 °C - 300 °C zur Entgasung aufgeheizt werden. In einer Vakuumkammer kann vor dem Beschichten auch ein Ionsputtern (Ätzprozess) zur zusätzlichen Reinigung und Aktivierung der Substratoberfläche durchgeführt werden. Hierfür können Metallionen in Argonatmosphäre (durch Gaseinlass) bei hohen elektrischen Spannungen an der mindestens einen Hilfselektrode von 500 V - 1500 V und innerhalb eines Druckbereichs von 0,1 Pa bis 1 Pa genutzt werden. Die maximale elektrische Spannung kann bei kontinuierlichen Betrieb elektrischer Lichtbögen auf 1000 V reduziert und bei gepulstem Betrieb mit maximal 1500 V gewählt werden.

Adhäsionsfördernde Zwischenschichten können in bekannter Weise mittels Abscheidung von Metallionen (z.B. Cr, Mo, Ti, Ag, Ta, Nb, Ru, Rh, W, V, Au, Zr, Al, Cu, Hf) in einem Druckbereich zwischen einem Druckbereich von 0,1 Pa und 1 Pa und Bias-Spannungen von 0 - 500 V an einer Hilfselektrode und/oder gitter- oder streifenförmigen Element vor Ausbildung einer Kohlenstoffschicht ausgebildet werden.

Die Vakuumkammer(n) und das bandförmige Substrat sollten an Erdpotential angeschlossen sein.

Eine Vakuumkammer sollte auch auf Temperaturen von 100 °C bis 400 °C vor der Durchführung nachfolgender Prozessschritte gebracht oder gehalten werden.

Eine Kohlenstoffschicht kann durch das Abscheiden bei hohen elektrischen Spannungen an der Anode von 50 V - 1000 V in einem Druckbereich 0,01 Pa bis 1 Pa ausgebildet werden. Hierdurch kann eine Subplantation erreicht werden. Bei gezündetem elektrischen Lichtbogen fließt ein elektrischer Strom im Bereich 5 A bis 30 A.

An einem gitter- oder streifenförmigen Element sollte eine elektrische Spannung im Bereich 5 V bis 1500 V angelegt sein.

Das Plasmanitrieren, das vor der Ausbildung der Kohlenstoffschicht an der Substratoberfläche durchgeführt werden kann, ist eine thermochemische Behandlung der Oberfläche von Stählen mit z.B. Stickstoff bei vergleichsweise niedrigen Temperaturen (T < 600 °C) und wird üblicherweise zur Verbesserung der Verschleißeigenschaften verwendet. Durch ein nachträgliches Carburieren mittels Abscheidung von Kohlenstoff, kann nicht nur die Korrosionsbeständigkeit, sondern auch die elektrische Leitfähigkeit der Bipolarplatte verbessert werden. Hierfür sollten allerdings niedrigere Nitriertemperaturen angewendet werden.

Beide Prozessschritte können unter den genannten Vakuumbedingungen durchgeführt werden. Durch das Anlegen einer hohen elektrischen Spannung zwischen Kathode und Anode kann das benötigte Plasma (ionisiertes Gas) generiert werden. Im Falle des Plasmanitrierens handelt es sich um ein Stickstoffplasma. Während der Kohlenstoffabscheidung kann für die gewünschte Dotierung ein zusätzliches Prozessgas, beispielsweise Flur oder Stickstoff, in die Vakuumkammer eingebracht werden. Es entsteht so ein gemischtes Plasma aus ionisierten Kohlenstoff- und Dotiergasatomen. Durch die Kohlenstoff-Subplantation kann die Substratoberfläche strukturiert werden und dabei kann nanokristalliner (dotierter) Kohlenstoff in der nitrierten Schicht erhalten werden. Somit kann eine Verbesserung der gewünschten Eigenschaften der Bipolarplatte, Elektrode oder elektrischem Stromableiter und letztlich der elektrochemischen Zelle erreicht werden.

Nachfolgend soll die Erfindung beispielshaft näher erläutert werden.

Dabei zeigen:
Figur 1 in schematischer Form einen Teil einer Vakuumkammer, die bei der Erfindung eingesetzt werden kann, in einer Seitenansicht;
Figur 2A eine Vorderansicht des in Figur 1 gezeigten Teils;
Figur 2B eine Vorderansicht des in Figur 1 gezeigten Teils mit einem elektrisch leitenden gitter- oder streifenförmigen Element;
Figur 3 A eine schematische Schnittdarstellung einer bei der erfindungsgemäßen Vorrichtung einsetzbaren Vakuumkammer und
Figur 3B ein weiteres Beispiel einer bei der erfindungsgemäßen Vorrichtung einsetzbaren Vakuumkammer jeweils in einer schematischen Schnittdarstellung.

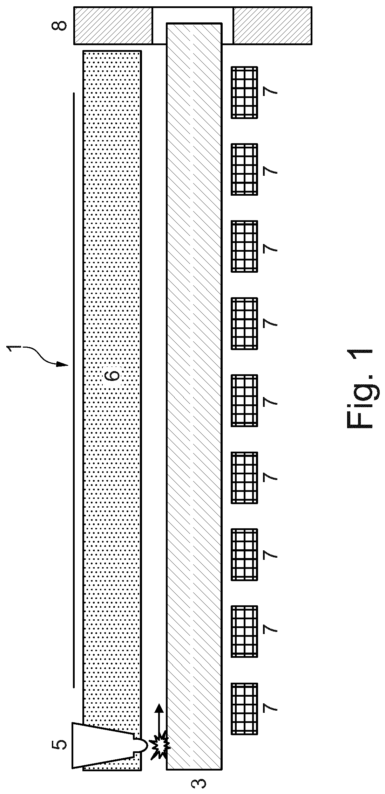

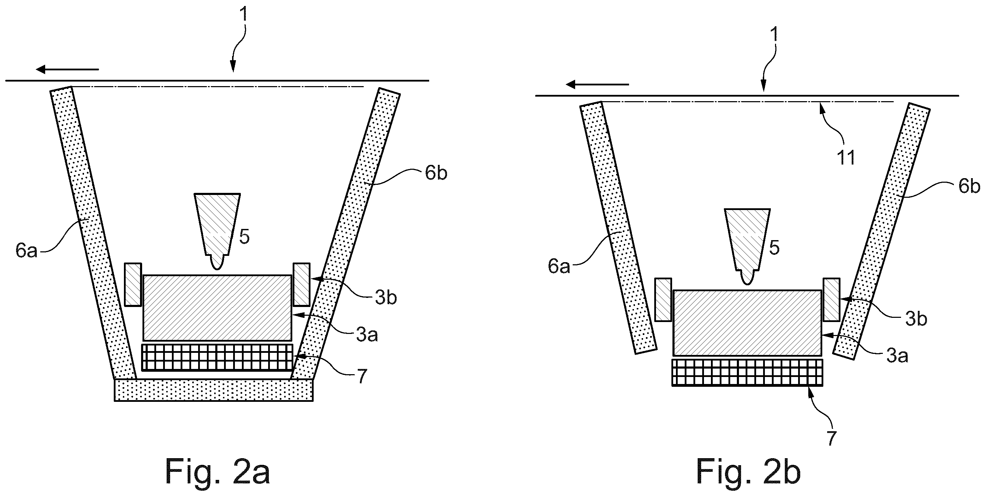

In Figuren 1 und 2A und 2B ist schematisch gezeigt, wie ein stabförmiges Target 3a aus Graphit in Bezug zu einer Anode 3b und einer Zündelektrode 5, einer Hilfselektrode 6, 6a, 6b, Permanent- oder Elektromagneten 7 sowie einem weiteren Permanent- oder Elektromagneten 8 prinzipiell angeordnet sein können. Die zwei plattenförmigen Elemente 6a und 6b, mit denen die Hilfselektrode 6 gebildet ist, sind in einem schräg geneigten Winkel und parallel zur Längsachse des stabförmigen Graphittargets 3a ausgerichtet, so dass sie eine umgekehrte Trichterwirkung für die Ionen ausüben können, mit denen die Kohlenstoffschicht als Beschichtung gebildet wird. Vorteilhaft können die Ionen dadurch in Richtung auf die jeweilige zu beschichtende Oberfläche des in den Figuren 1 und 2 nicht gezeigten bandförmigen Substrats 1 aus Edelstahl beschleunigt werden.

Aus Figuren 2A und 2B kann man eine keilförmige Anordnung plattenförmiger Elemente 6a und 6b als Hilfselektrode entnehmen. Zwischen den sich konisch in Richtung bandförmigem Substrat 1 konisch erweiternd angeordneten plattenförmigen Elementen 6a und 6b sind das stabförmige Target 3a und die Anode 3b angeordnet. Unter dem stabförmigen Target 3a sind die Permanent- oder Elektromagnete 7 schematisch angedeutet. Der horizontale Pfeil oberhalb des bandförmigen Substrats 1 deutet die Vorschubbewegungsrichtung des Substrats 1 an.

Die die Hilfselektrode bildenden plattenförmigen Elemente 6a und 6b können auch in nicht dargestellter Form durch ein einziges plattenförmiges Element ersetzt werden, das dann v-förmig oder u-förmig oder konkav gekrümmt ausgebildet bzw. verformt und ähnlich wie in Figuren 2A und 2B angeordnet sein kann.

In Figur 2B ist das in Figur 2A gezeigte Beispiel mit einem gitter- oder streifenförmigen Element 11 ergänzt, das zwischen der Anordnung mit dem stabförmigen Target 3a, der Anode 3b, der Zündelektrode 5 und der Oberkante in Richtung Substrat 1 und der zu beschichtenden Oberfläche des bandförmigen Substrats 1 angeordnet. Das Element 11 ist dabei mit dem Gitter oder seinen Streifen parallel zur Oberfläche des Substrats 1 angeordnet und an den negativen Pol der zweiten elektrischen Spannungsquelle 9 angeschlossen.

Der Absolutbetrag der negativen elektrischen Spannung, die am gitter- oder streifenförmigen Element 11 wirkt, ist erheblich größer, als der der an der mit den plattenförmigen Elementen 6a und 6b gebildeten Hilfselektrode.

In nicht gezeigter Ausführungsform kann auf eine mit mindestens einem plattenförmigen Element gebildeten Hilfselektrode 6b auch verzichtet und für eine Beschleunigung von Ionen in Richtung der zu beschichtenden Oberfläche des bandförmigen Substrats 1 lediglich das weitere gitter- oder streifenförmige Element 11 genutzt werden.

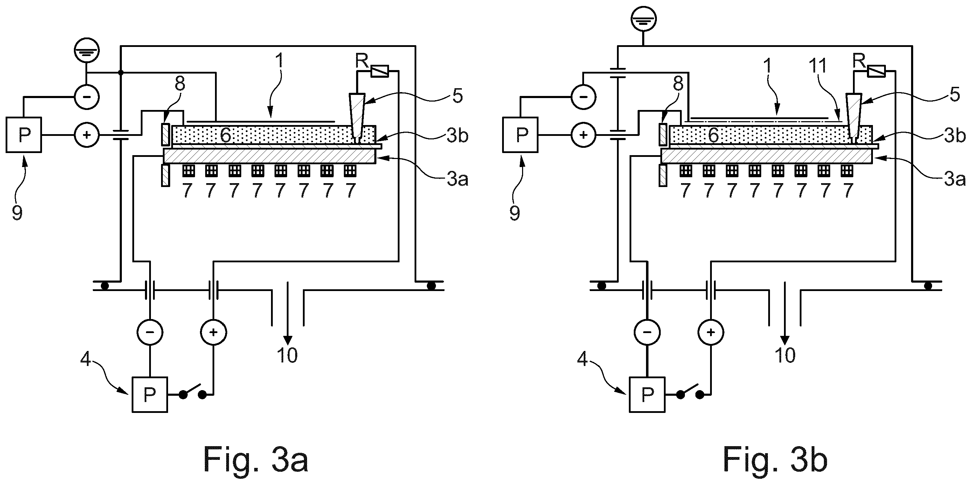

Mit den schematischen Darstellungen in Figur 3a und 3b kann verdeutlicht werden, wie weitere Elemente einer Vorrichtung zueinander angeordnet und ausgebildet sein können.

So ist die erste elektrische Spannungsquelle 4 einmal mit dem negativen Pol des stabförmigen Graphittargets 3a und zum andern mit einem positiven Pol an einer Stirnseite des stabförmigen Graphittargets 3 in einem Abstand zu dieser fest installierte Zündelektrode bzw. Anode 5 elektrisch leitend verbunden.

Parallel zur Oberfläche des stabförmigen Graphittargets 3, auf der die Fußpunkte gezündeter elektrischer Lichtbogenentladungen zwischen Zündelektrode bzw. Anode 5, Hilfselektrode 6 und stabförmigem Graphittarget 3 zur Plasmabildung geführt sind, wird das bandförmige Substrat 1 translatorisch durch die Vakuumkammer 2 geführt, um eine Kohlenstoffschicht auf einer Oberfläche des bandförmigen Substrats 1 auszubilden.

Unterhalb des stabförmigen Graphittargets 3 sind bei diesem gezeigten Beispiel acht Permanent- oder Elektromagnete 7 in einer Reihenanordnung angeordnet. An der gegenüberliegenden Stirnseite, zu der Stirnseite an der die Anode 5 angeordnet ist, ist ein weiterer Permanent- oder Elektromagnet 8 angeordnet, mit dem ein elektrischer Lichtbogen gelöscht wird, wenn sein Fußpunkt in den Einflussbereich des vom weiteren Permanent- oder Elektromagneten 8 generierten Magnetfeldes gelangt.

Die plattenförmigen Elemente 6a und 6b, mit denen die Hilfselektrode 6 gebildet ist, oder eine konkav gekrümmte Hilfselektrode 6 ist/ sind an den positiven Pol einer zweiten elektrischen Spannungsquelle 9 angeschlossen.

Die Vakuumkammer 2 und/oder das bandförmige Substrat 1 sind auf Erdpotential gelegt.

An der Vakuumkammer 2 ist auch ein Anschluss 10 über den ein Abpumpen zur Einhaltung eines ausreichenden Vakuums in der Vakuumkammer 2 möglich ist, dargestellt.

## Patentansprüche

1. Vorrichtung zur Oberflächenbeschichtung eines bandförmigem Substrats aus einem Metall für die Herstellung von Bipolarplatten, Elektroden oder elektrischen Stromableitern für elektrochemische Zellen mit einer Beschichtung, die mit Metall oder Kohlenstoff gebildet ist, bei der
das bandförmige Substrat (1) in einer Vakuumkammer (2) in einem Abstand zu einem stabförmigen Target (3a angeordnet und parallel zur Längsachse des stabförmigen Targets (3a), das aus einem Metall oder Kohlenstoff besteht, ausgerichtet ist;
das stabförmige Target (3a) an den negativen Pol einer ersten elektrischen Spannungsquelle (4) angeschlossen ist und
in einem Abstand zu dem stabförmigen Target (3a) eine Anode (3b), die an den positiven Pol der ersten elektrischen Spannungsquelle (4) angeschlossen ist, angeordnet ist, wobei
die erste elektrische Spannungsquelle (4) gepulst oder kontinuierlich zur Zündung und Aufrechterhaltung elektrischer Bogenentladungen zwischen der Anode (3b) und dem stabförmigen Target (3a) betrieben ist, und
mindestens eine Hilfselektrode (6, 6a, 6b), die an einen positiven Pol einer zweiten elektrischen Spannungsquelle (9) angeschlossen ist, und
das stabförmige Target (3a) innerhalb von Schenkeln einer v-förmig oder u-förmig konkav in Richtung des stabförmigen Targets (3a) gekrümmten Hilfselektrode (6) oder in einem Spalt zwischen einer mit mindestens zwei plattenförmigen Elementen (6a, 6b) gebildeten Hilfselektrode in einem Abstand zu der v-förmig oder u-förmig konkav gekrümmten Hilfselektrode (6) oder den plattenförmigen Elementen (6a, 6b) so angeordnet ist, dass mit elektrischen Lichtbogenentladungen vom stabförmigen Target (3a) freigesetzte Metall- oder Kohlenstoffionen durch die in Richtung auf das stabförmige Target (3a) offene Hilfselektrode (6, 6a, 6b) zum bandförmigen Substrat (1) gelangen.

2. Vorrichtung nach Anspruch 1, **dadurch gekennzeichnet, dass** an einem stirnseitigen Rand des stabförmigen Targets (3a) in einem Abstand zu dem stabförmigen Target (3a) eine an den positiven Pol der ersten elektrischen Spannungsquelle (4) angeschlossene Zündelektrode (5) für eine Zündung elektrischer Bogenentladungen angeordnet ist.

3. Vorrichtung nach einem der vorhergehenden Ansprüche, **dadurch gekennzeichnet, dass** ein elektrisch leitendes, streifen- oder gitterförmiges Element (11) parallel zur Oberfläche des bandförmigen Substrats (1) ausgerichtet, zwischen der Hilfselektrode (6, 6a, 6b) und dem bandförmigen Substrat (1) angeordnet und an den negativen Pol der zweiten elektrischen Spannungsquelle angeschlossen ist.

4. Vorrichtung nach einem der vorhergehenden Ansprüche, **dadurch gekennzeichnet, dass** mehrere Permanent- oder Elektromagnete (7) in einer Reihenanordnung zumindest an der Seite des stabförmigen Targets (3a) die dem bandförmigen Substrat (1) abgewandt ist, mit jeweils einem Abstand zwischen den einzelnen Permanent- oder Elektromagneten (7) ausgehend von einem stirnseitigen Ende des stabförmigen Targets (3a) bis zu dessen gegenüberliegend angeordneten stirnseitigen Endes angeordnet sind.

5. Vorrichtung nach einem der vorhergehenden Ansprüche, **dadurch gekennzeichnet, dass** ein weiterer Permanent- oder Elektromagnet (8) am stirnseitigen Ende des stabförmigen Targets (3a), das dem stirnseitigen Ende, an dem die Anode (3b) angeordnet ist, gegenüberliegt, angeordnet und so ausgebildet oder betreibbar ist, dass ein gezündeter elektrischer Lichtbogen ausgelöscht wird, wenn sein Fußpunkt an der Oberfläche des stabförmigen Targets (3a) den Bereich des Magnetfeldes des einen weiteren Permanent- oder Elektromagneten (8), der am stirnseitigen Ende des stabförmigen Targets (3a) angeordnet ist, erreicht hat.

6. Vorrichtung nach einem der vorhergehenden Ansprüche, **dadurch gekennzeichnet, dass** die Permanent- oder Elektromagneten (7) ausgehend von dem stirnseitigen Ende des stabförmigen Graphittargets (3), an dem die Anode (5) angeordnet ist, bis zu dem gegenüberliegend angeordneten stirnseitigen Ende des stabförmigen Targets (3a) Magnetfelder mit jeweils gleicher Ausrichtung der Feldlinien generieren, wobei
die Feldstärkte der von den Permanent- oder Elektromagneten (7) generierten Magnetfelder ausgehend von dem stirnseitigen Ende des stabförmigen Targets (3a), an dem die Anode (3b) angeordnet ist, bis zu dem gegenüberliegend angeordneten stirnseitigen Endes des stabförmigen Targets (3a) bevorzugt kontinuierlich ansteigt und/oder sich der Abstand zwischen unmittelbar nebeneinander angeordneten Permanent- oder Elektromagneten (7) in dieser Richtung verkleinert.

7. Vorrichtung nach einem der vorhergehenden Ansprüche, **dadurch gekennzeichnet, dass** der weitere Permanent- oder Elektromagnet (8) ein Magnetfeld generiert dessen Polung entgegengesetzt zu den von den Permanent- oder Elektromagneten (7) generierten Magnetfeldern ist und/oder das vom weiteren Permanent- oder Elektromagnet (8) generierte Magnetfeld eine größere Feldstärke als die Magnetfelder der von den Permanent- oder Elektromagneten (7) generierten Magnetfelder aufweist und/oder
der weitere Permanent- oder Elektromagnet (8) über die in Richtung des bandförmigen Substrats (1) weisende Oberfläche des stabförmigen Graphittargets hinausragt.

8. Vorrichtung nach einem der vorhergehenden Ansprüche, **dadurch gekennzeichnet, dass** mehrere Vakuumkammern (2) gemäß einem der vorhergehenden Ansprüche in Vorschubbewegungsrichtung des bandförmigen Substrats (1) nacheinander in einer Reihenanordnung zur Ausbildung der Beschichtung, die mit dem Metall oder Kohlenstoff des stabförmigen Targets (3a) gebildet ist, eine erste Vakuumkammer, die für eine Plasmafeinreinigung ausgebildet ist, anschließend an die erste Vakuumkammer eine zweite Vakuumkammer, die für eine Modifizierung an der Oberfläche des bandförmigen Substrats (1) in Form einer Nitrierung, Carburierung und/oder Nitrier-Carburierung und/oder zur Ausbildung einer metallischen Zwischenschicht, ausgebildet ist und daran nachfolgend mindestens eine weitere Vakuumkammer, die zur Beschichtung des bandförmigen Substrats (1) mit dem Metall des stabförmigen Targets (3a) oder mit dem Kohlenstoff ausgebildet ist, nacheinander angeordnet sind.

9. Vorrichtung nach einem der vorhergehenden Ansprüche, **dadurch gekennzeichnet, dass** an einer Vakuumkammer (2) ein Mehrkammersystem vorhanden ist, in dem stabförmige Targets (3a) aufgenommen sind und durch eine Manipulation des Mehrkammersystems ein Austausch eines verbrauchten stabförmigen Targets (3a) gegen ein neues unverbrauchtes stabförmiges Target (3a) erreichbar ist, bei dem keine Unterbrechung der Vakuumbedingungen in der jeweiligen Vakuumkammer (2) erforderlich ist.

10. Vorrichtung nach einem der vorhergehenden Ansprüche, **dadurch gekennzeichnet, dass** an die mindestens eine Hilfselektrode (6, 6a, 6b, 11) eine elektrische Spannung zwischen 5 V und 1500 V angelegt ist.

11. Vorrichtung nach einem der vorhergehenden Ansprüche, **dadurch gekennzeichnet, dass** die Hilfselektrode (6, 6a, 6b) gekühlt ist.

## Claims

1. Device to surface coat a ribbon-shaped substrate of a metal for the manufacture of bipolar plates, electrodes or electrical current conductors for electrochemical cells with a coating formed with metal or carbon, in which
the ribbon-shaped substrate (1) is arranged in a vacuum chamber (2) at a distance from a rod-shaped target (3a) and is aligned parallel to the longitudinal axis of the rod-shaped target (3a), which is made of a metal or carbon;
the rod-shaped target (3a) is connected to the negative pole of a first electrical voltage source (4), and
an anode (3b), which is connected to the positive pole of the first electrical voltage source (4), is arranged at a distance from the rod-shaped target (3a), wherein
the first electrical voltage source (4) is operated in pulsed or continuous mode to ignite and maintain electrical arc discharges between the anode (3b) and the rod-shaped target (3a), and
at least one auxiliary electrode (6, 6a, 6b), which is connected to a positive pole of a second electrical voltage source (9), and
the rod-shaped target (3a) is arranged within the legs of an auxiliary electrode (6) concavely curved in a V-shape or a U-shape towards the rod-shaped target (3a) or in a gap between an auxiliary electrode formed with at least two plate-like elements (6a, 6b) at a distance from the auxiliary electrode (6) concavely curved in a V-shape or a U-shape or the plate-like elements (6a, 6b) so that metal or carbon ions released by electric arc discharges from the rod-shaped target (3a) pass through the auxiliary electrode (6, 6a, 6b), which is open towards the rod-shaped target (3a), to the ribbon-shaped substrate (1).

2. The device according to claim 1, **characterised in that** an ignition electrode (5) connected to the positive pole of the first electrical voltage source (4) for igniting electrical arc discharges is arranged at a distance from the rod-shaped target (3a) on an end face of the rod-shaped target (3a).

3. The device according to any one of the preceding claims, **characterised in that** an electrically conductive strip- or grid-shaped element (11) is aligned parallel to the surface of the strip-shaped substrate (1), arranged between the auxiliary electrode (6, 6a, 6b) and the strip-shaped substrate (1) and is connected to the negative pole of the second electrical voltage source.

4. The device according to any one of the preceding claims, **characterised in that** a plurality of permanent or electromagnets (7) are arranged in a row at least on the side of the rod-shaped target (3a) facing away from the strip-shaped substrate (1), with a distance between the individual permanent or electromagnets (7) starting from one end face of the rod-shaped target (3a) to its opposite end face.

5. The device according to any one of the preceding claims, **characterised in that** a further permanent magnet or electromagnet (8) is arranged at the end face of the rod-shaped target (3a), which is opposite the end face at which the anode (3b) is arranged, and is configured or can be operated such that an ignited electric arc is extinguished when its base point on the surface of the rod-shaped target (3a) reaches the area of the magnetic field of the further permanent or electromagnet (8), located at the end face of the rod-shaped target (3a).

6. The device according to any one of the preceding claims, **characterised in that** the permanent or electromagnets (7) generate magnetic fields with field lines of the same orientation from the front end of the rod-shaped graphite target (3) on which the anode (5) is arranged, up to the oppositely arranged front end of the rod-shaped target (3a), generating magnetic fields with field lines that are each aligned in the same direction, whereby
the field strength of the magnetic fields generated by the permanent or electromagnets (7) starting from the end face of the rod-shaped target (3a) to which the anode (3b) is attached, to the opposite end face of the rod-shaped target (3a), and/or the distance between permanent or electromagnets (7) arranged directly next to each other decreases in this direction.

7. The device according to any one of the preceding claims, **characterised in that** the further permanent magnet or electromagnet (8) generates a magnetic field whose polarity is opposite to that of the magnetic fields generated by the permanent or electromagnets (7) and/or the magnetic field generated by the further permanent or electromagnet (8) has a greater field strength than the magnetic fields generated by the permanent or electromagnets (7) and/or
the further permanent magnet or electromagnet (8) protrudes beyond the surface of the rod-shaped graphite target facing the strip-shaped substrate (1).

8. The device according to any one of the preceding claims, **characterised in that** a plurality of vacuum chambers (2) according to any one of the preceding claims are in a row arrangement in the feed direction of the strip-shaped substrate (1) to form the coating, which is formed with the metal or carbon of the rod-shaped target (3a), a first vacuum chamber designed for plasma fine cleaning, followed by a second vacuum chamber designed for modifying the surface of the strip-shaped substrate (1) in the form of a nitration, carburisation and/or nitration-carburisation and/or for forming a metallic intermediate layer, and then at least one further vacuum chamber configured for coating the strip-shaped substrate (1) with the metal of the rod-shaped target (3a) or with the carbon.

9. The device according to one of the preceding claims, **characterised in that** a vacuum chamber (2) in which rod-shaped targets (3a) are accommodated and by manipulating the multi-chamber system, a used rod-shaped target (3a) can be replaced with a new, unused rod-shaped target (3a) without any interruption of the vacuum conditions in the respective vacuum chamber (2).

10. The device according to one of the preceding claims, **characterised in that** an electrical voltage between 5 V and 1500 V is applied to the at least one auxiliary electrode (6, 6a, 6b, 11).

11. The device according to any one of the preceding claims, **characterised in that** the auxiliary electrode (6, 6a, 6b) has been cooled.

## Revendications

1. Dispositif de revêtement de surface d'un substrat en forme de bande et constitué de métal en vue de la fabrication de plaques bipolaires, d'électrodes ou de dissipateurs de courant électrique pour des cellules électrochimiques comprenant un revêtement formé de métal ou de carbone, dans lequel
le substrat en forme de bande (1) est placé dans une chambre à vide (2) à une certaine distance d'une cible en forme de barreau (3a et est orienté parallèlement à l'axe longitudinal de la cible en forme de barreau (3a), qui est constituée de métal ou de carbone ;
la cible en forme de barreau (3a) est connectée au pôle négatif d'une première source de tension électrique (4) et
une anode (3b), qui est connectée au pôle positif de la première source de tension électrique (4), est agencée à une certaine distance de la cible en forme de barreau (3a), dans laquelle
la première source de tension électrique (4) fonctionne de manière pulsée ou continue afin d'allumer et d'entretenir des décharges électriques en arc entre l'anode (3b) et la cible en forme de barreau (3a), et
au moins une électrode auxiliaire (6, 6a, 6b) est connectée à un pôle positif d'une deuxième source de tension électrique (9), et
la cible en forme de barreau (3a) est agencée à l'intérieur des branches d'une électrode auxiliaire (6) courbée dans la direction de la cible en forme de barreau (3a) de manière concave en forme de V ou en forme de U ou dans un espace circonscrit par une électrode auxiliaire formée d'au moins deux éléments en forme de plaque (6a, 6b), à une certaine distance de ladite électrode auxiliaire (6) courbée de manière concave en forme de V ou en forme de U ou des dits éléments en forme de plaque (6a, 6b), de sorte que des ions métalliques ou carbone libérés de la cible en forme de barreau (3a) par les décharges électriques en arc parviennent au substrat en forme de bande (1) grâce à l'électrode auxiliaire (6, 6a, 6b) ouverte en direction de la cible en forme de barreau (3a).

2. Dispositif selon la revendication 1, **caractérisé en ce qu'**une électrode d'amorçage (5), connectée au pôle positif de la première source de tension électrique (4), est agencée au niveau d'un bord frontal de la cible en forme de barreau (3a), à une certaine distance de la cible en forme de barreau (3a), en vue d'un amorçage de décharges d'arc électrique.

3. Dispositif selon l'une quelconque des revendications précédentes, **caractérisé en ce qu'**un élément électriquement conducteur en forme de bande ou de grille (11) est aligné parallèlement à la surface du substrat en forme de bande (1), est agencé entre l'électrode auxiliaire (6, 6a, 6b) et le substrat en forme de bande (1), et est connecté au pôle négatif de la seconde source de tension électrique.

4. Dispositif selon l'une quelconque des revendications précédentes, **caractérisé en ce que** plusieurs aimants permanents ou électro-aimants (7) sont agencés en série au moins sur le côté de la cible en forme de barreau (3a) qui est opposé au substrat en forme de bande (1), avec respectivement une distance entre les différents aimants permanents ou électro-aimants (7) allant d'une extrémité frontale de la cible en forme de barreau (3a) jusqu'à son extrémité frontale agencée à l'opposé.

5. Dispositif selon l'une quelconque des revendications précédentes, **caractérisé en ce qu'**un autre aimant permanent ou électro-aimant (8) est agencé au niveau de l'extrémité frontale, opposée à l'extrémité frontale au niveau de laquelle est agencée l'anode (3b), de la cible en forme de barreau (3a) et est réalisé ou peut être utilisé de sorte qu'un arc électrique amorcé est éteint lorsque son point de base à la surface de la cible en forme de barreau (3a) a atteint la région du champ magnétique d'un autre aimant permanent ou électro-aimant (8) agencé au niveau de l'extrémité frontale de la cible en forme de barreau (3a).

6. Dispositif selon l'une quelconque des revendications précédentes, **caractérisé en ce que** les aimants permanents ou électro-aimants (7) génèrent des champs magnétiques, avec respectivement la même orientation des lignes de champ, à partir de l'extrémité frontale de la cible en graphite en forme de barreau (3) au niveau de laquelle est agencée l'anode (5) jusqu'à l'extrémité frontale, située à l'opposé, de la cible en forme de barreau (3a),
les intensités de champ des champs magnétiques générés par les aimants permanents ou électro-aimants (7) augmentent de manière préférée en continu à partir de l'extrémité frontale, au niveau de laquelle est agencée l'anode (3b), de la cible en forme de barreau (3a) jusqu'à l'extrémité frontale opposée de la cible en forme de barreau (3a) et/ou la distance entre des aimants permanents ou électro-aimants (7) immédiatement adjacents diminue dans ladite direction.

7. Dispositif selon l'une quelconque des revendications précédentes, **caractérisé en ce que** l'autre aimant permanent ou électro-aimant (8) génère un champ magnétique dont la polarité est opposée aux champs magnétiques générés par les aimants permanents ou électro-aimants (7) et/ou **en ce que** le champ magnétique généré par l'autre aimant permanent ou électro-aimant (8) présente une intensité de champ supérieure à celle des champs magnétiques générés par les aimants permanents ou électro-aimants (7) et/ou
l'autre aimant permanent ou électroaimant (8) dépasse de la surface, orientée en direction du substrat en forme de bande (1), de la cible en graphite en forme de barreau.

8. Dispositif selon l'une quelconque des revendications précédentes, **caractérisé en ce que** plusieurs chambres à vide (2) selon l'une quelconque des revendications précédentes, agencées en série les unes derrière les autres dans la direction de déplacement d'avancée du substrat en forme de bande (1) afin de créer le revêtement constitué du métal ou du carbone de la cible en forme de barreau (3a), une première chambre à vide conçue pour un nettoyage fin au plasma, une seconde chambre à vide se raccordant à la première chambre à vide et conçue pour une modification à la surface du substrat en forme de bande (1) sous la forme d'une nitruration, d'une carburation et/ou d'une nitrocarburation et/ou conçue en vue de la réalisation d'une couche intermédiaire métallique, et ensuite au moins une autre chambre à vide conçue pour revêtir le substrat en forme de bande (1) avec le métal de la cible en forme de barreau (3a) ou avec le carbone, sont agencées les unes derrière les autres.

9. Dispositif selon l'une quelconque des revendications précédentes, **caractérisé en ce qu'**un système à plusieurs chambres, au sein duquel des cibles en forme de barreau (3a) sont accueillies, est présent au niveau d'une chambre à vide (2) et **en ce qu'**un remplacement d'une cible en forme de barreau (3a) usagée par une nouvelle cible en forme de barreau (3a) non usagée peut être obtenu grâce à une manipulation du système à plusieurs chambres, aucune interruption des conditions de vide au sein de la chambre à vide (2) respective n'étant nécessaire.

10. Dispositif selon l'une quelconque des revendications précédentes, **caractérisé en ce qu'**une tension électrique comprise entre 5 V et 1500 V est appliquée à la au moins une électrode auxiliaire (6, 6a, 6b, 11).

11. Dispositif selon l'une quelconque des revendications précédentes, **caractérisé en ce que** l'électrode auxiliaire (6, 6a, 6b) est refroidie.
